(19) Europäisches Patentamt

European Patent Office

Office européen des brevets

(11) **EP 0 745 266 B1**

(12) **EUROPEAN PATENT SPECIFICATION**

(45) Date of publication and mention
of the grant of the patent:
**14.05.2003 Bulletin 2003/20**

(51) Int Cl.[7]: **H01J 3/26**, H01J 37/145,
H01J 37/153

(21) Application number: **95904093.2**

(22) Date of filing: **18.11.1994**

(86) International application number:
**PCT/US94/13358**

(87) International publication number:
**WO 96/016426 (30.05.1996 Gazette 1996/25)**

(54) **CHROMATICALLY COMPENSATED PARTICLE-BEAM COLUMN**

CHROMATISCH KOMPENSIERTE TEILCHENSTRAHLSÄULE

COLONNE DE FAISCEAU PARTICULAIRE A COMPENSATION CHROMATIQUE

(84) Designated Contracting States:
**CH DE DK ES FR GB IE IT LI NL SE**

(43) Date of publication of application:
**04.12.1996 Bulletin 1996/49**

(73) Proprietor: **Martin, Frederick Wight**
**North Stratford, NH 03590 (US)**

(72) Inventor: **Martin, Frederick Wight**
**North Stratford, NH 03590 (US)**

(74) Representative: **Brown, David Leslie et al**
**Haseltine, Lake & Co,**
**Imperial House,**
**15-19 Kingsway**
**London WC2B 6UD (GB)**

(56) References cited:
**US-A- 4 555 666**         **US-A- 4 590 379**
**US-A- 4 684 808**

- **KELMAN V.M.; YAVOR S.YA.: "A quadrupole
  lens with negative aberration" SOVIET
  PHYSICS-TECHNICAL PHYSICS, vol. 8, no. 3,
  September 1963, USA, pages 271-272,
  XP002047863**
- **HARRIOTT L R ET AL: "ACHROMATIC
  QUADRUPOLE FOCUSING SYSTEMS FOR USE
  WITH LIQUID METAL ION SOURCES" JOURNAL
  OF VACUUM SCIENCE AND TECHNOLOGY:
  PART B, vol. 8, no. 6, 1 November 1990, pages
  1706-1710, XP000169137**
- **HARRIOT L.R.; BROWN W.L.; BARR D.L.:
  "Anticipated performance of achromatic
  quadrupole focusing systems when used with
  liquid metal ion sources." JOURNAL OF
  VACUUM SCIENCE TECHNOLOGY A, vol. 8, no.
  4, July 1990, USA, pages 3279-3283,
  XP002047864**
- **SMITH M R ET AL: "ACHROMATIC LENS AND
  MASS FILTER DESIGN USING CROSSED-FIELD
  MULTIPOLE ELEMENTS" EXTENDED
  ABSTRACTS, vol. 88-2, 21 September 1988, page
  665/666 XP000049099**

**Description**

The US government has a paid-up license in this invention and the right in limited circumstances to require the patent owner to license others on reasonable terms as provided by the terms of grant number ISI85 21 280 awarded by the National Science Foundation.

Technical Field of the Invention

The invention pertains to the field of ion optics, as it is used in equipment for forming finely focused ion beams, used generally in such fields as microfabrication and microanalysis, such as ion implantation in semiconductors, micromachining of materials, ion beam lithography, and secondary ion microscopy.

Background Art of the Invention

In the prior art, equipment used to make fine beams generally consists of a needle-type source of particles which may emit electrons or cause ionization of surrounding gas, involve surface ionization at low temperatures, or most commonly is a needle wet with a liquid metal or alloy containing a desired ion. In some cases a single lens is used to form an image of the very small emitting region of the source. [R.L. Seliger, J.W. Ward, V. Wang, and R.L. Kubena, Applied Physics Letters 34 (1979) 210]. Greater intensity is obtained by using a condensing lens near the source or a plurality of condensing lenses. When several lenses are used, it is possible to make an intermediate image of the source; and if the intermediate image is placed at the center of an ion-optical component such as an accelerating gap [V. Wang, J.W. Ward, and R.L. Seliger, Journal of Vacuum Science and Technology 19 (1981) 1158], or a Wien filter [N. Anazawa, R. Aihara, E. Ban, and M. Okunuki, "Ion Optical System for Maskless Ion Implantation with 100nm Resolution" in Electron-Beam Techniques for Submicron Lithographies II, P.D. Blais, editor, Proceedings SPIE 393 (1983) xxx], the aberrations caused by the component are greatly reduced. However the focusing ability of all systems utilizing electrostatic lenses is limited by the chromatic aberration of these lenses in combination with the unavoidable energy spread of ions emerging from the ion source. The full width d of the final focal spot is given by formulae of the type

$$d = C \, a \, dE/E \,, \qquad d = C \, b \, dE/E$$

where dE is the spread of energies about the central energy E of the ions, a and b are the full angles of convergence at the final focus in the two principal sections of the column, and C is a chromatic aberration coefficient. Chromatic aberration differs from other aberrations in its first-order dependence upon a. For example the spherical aberration of a round lens varies as $a^3$.

Thus 1st-order chromatic aberration is important at small lens apertures, where spherical has become very small, and 3rd-order spherical aberration will dominate at some large value of a.

The insufficient focusing ability of electrostatic systems causes limitations to ion-optical devices which have been longstanding difficulties in the prior art. In applications such as micromachining, the current density is of prime importance. The current from a liquid metal ion source is given by

$$I = B \, a_s b_s \, r^2$$

where typical numbers are brightness $B = 10^6$ A/sr-cm$^2$, emission angles $a_s$, $b_s$ = 400 milliradians, and effective source radius smaller than r = 100 Angstroms. Because the effective source is so small, the size of the beam is given by d rather than by the geometrical image of the source. Accordingly the current density J is given by

$$J = I / d^2 = B(a_s b_s/ab)(rE/C \, dE)^2$$

Since the quantity E/C is roughly constant in electrostatic lenses it has been stated that "the maximum current density obtained of about 1 A/cm$^2$ will not be increased substantially in the near future."[A. Wagner, "Applications of Focused Ion Beams to Microlithography", Solid State Technology (May 1983) 97], Even complicated electrostatic lenses containing four electrodes produce a maximum of 10 A/cm$^2$. [K. Kurihara, Journal of Vacuum Science and Technology B3-1 (1985) 43]. To overcome this longstanding difficullty, an object of the present invention is to increase current density, by utilizing achromatic lenses in which C = 0.

When covering a large specimen area is desired, such as in maskless ion implantion for fabrication of application-specific integrated circuits, the current rather than the current density becomes important. At 1 nA current, the time to write a 4-inch wafer at a dose of $10^{13}$ ions/cm$^2$ in a single-lens system is about an hour. The low current has been a difficulty in such equipment. [B.W. Ward, N.P. Economu, D.C. Shaver, J. E. Ivory, M. L. Ward, and L.A. Stern, "Microcircuit Modification Using Focused Ion Beams", in Electron-Beam, X-Ray, and Ion-Beam Technology: Submicrometer Lithographies VII", A.W. Yanof, editor, Proceedings SPIE 923 (1988) 97]. Larger currents may be obtained in a system with a plurality of lenses, which allow operation with larger values of a and b. However such increased angles introduce aberrations which may make the focused beam larger than the desired feature size. For angles smaller than the knee angle at which chromatic and other aberrations are equal, removal of chromatic aberration will result in a larger operating angle and a larger current for any given focused beam size. Accordingly, an object of the present invention is to produce higher currents and allow microfabrication at higher writing speeds, by utilizing complete achromatic systems in which C = 0.

Brief Disclosure of Invention

Ion beam columns comprising liquid metal ion sources and a plurality of electrostatic lenses cannot produce fine beams fcoused to a spot as small as the image of the ion source. Instead the spread of energies of ions emitted from the source produces a variation in focal length which blurs and enlarges the image. Chromatic aberration of this sort is a property of all electrostatic and solely magnetic lenses. The novel column of the invention, utilising a condensing lens and a doublet of interleaved quadrupole lenses, is defined in general terms in Claim 12 of the appended claims. By adjustment of the electric-to-magnetic ratio, the interleaved lenses may be made achromatic, whereby the chromatic aberration of the column is greatly reduced, or may be made to have negative chromatic aberration, whereby the chromatic aberration of the column is entirely eliminated. These operating methods are defined in general terms in Claims 1 and 3 of the appended claims.

A mass-separating ion-beam column which removes unwanted ions produced by a liquid alloy ion source, of use in the field of ion implantation, comprises such a column with a Wien velocity filter located after the ion source. Such a column can be short and uncurved, but also produce ions of a single atomic number in the final focus.

Elimination of chromatic aberration also allows larger apertures to be used within the lenses, so that a higher beam current is produced at a given focused beam spot size. Aperture size is then limited by higher-order aberrations, rather than by 1st-order chromatic aberration

Brief Description of Drawings

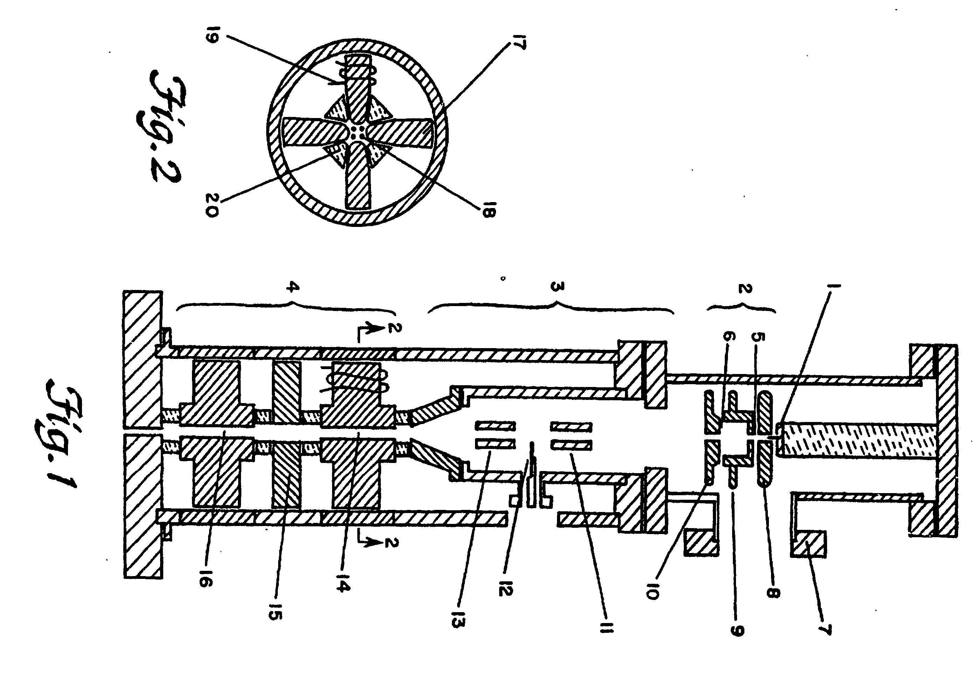

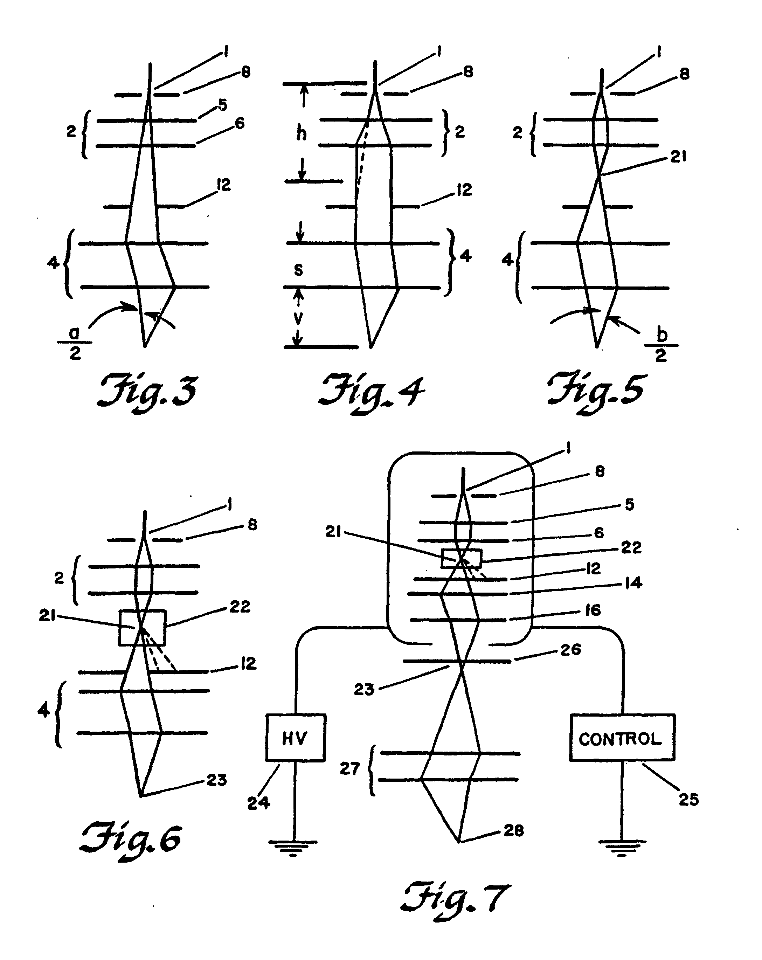

Fig. 1 presents a cross section of an achromatic ion beam column. Fig. 2 presents a cross section of an interleaved quadrupole lens. Figs. 3-7 are diagrams of achromatic columns in which typical rays in the two principal sections of the optical system are shown. Fig. 3 presents a column containing an inactive condensing lens and substantially achromatic interleaved lenses. In Figs. 4-7 negative chromatic aberration in the interleaved lenses is used to correct the chromatic aberration of the other lenses in the column. In Fig. 4 the condensing lens converges the ions into a parallel beam. In Fig. 5 the condensing lens converges the ions into a crossover. Fig. 6 shows a mass-separating achromatic ion beam column, and Fig. 7 shows a mass-separating achromatic system for forming finely focused beams at higher energies than are feasible with a two-lens column.

Modes for Carrying Out the Invention

The liquid metal ion source 1 of the ion beam column usually is placed at many kilovolts negative potential with respect to a nearby extracting electrode 8, which typically is a flat surface with a hole drilled through it to allow passage of the ion beam. As is well known in ion and electron optics, this forms an "aperture lens" which has a diverging lens action. An ion pump attached to port 7 is provided to produce $10^{-8}$ Torr vacuum near the ion source.

Beyond the extraction electrode is a condenser lens system 2 which if adjusted properly can converge the ions into a parallel beam. A single condenser lens may be used, but since the extraction of ions proceeds well only over a narrow range of voltages, and the focusing action of the single gap also requires a fixed voltage, the output energy is substantially fixed. Therefore a two-lens condenser system is useful as a means of providing variable ion energy. The electrodes 8, 9, 10 form one such condensing lens system, in which the gaps 5,6 between the three electrodes form two round electrostatic lenses. The ion source and electrodes are maintained at the required potentials by high voltage power supplies according to means well known in prior art.

Ions leaving the condenser lens 2 pass through a drift space 3 and enter an interleaved quadrupole lens system 4. In the drift space are located multipole deflectors 11, 13 which are capable of deflecting ions in a plane in any azimuth about the beam axis, and an aperture-defining assembly 12 composed of four independent non-interfering vanes, only one of which is shown for clarity.

As shown in Fig. 2, interleaved quadrupole lenses contain 8 poles with centers equally spaced in azimuth about the beam direction. The poles are alternately magnetic poles 17 and electric poles 18, thereby forming an electric quadrupole lens and a magnetic quadrupole lens. The 45 degree spacing of the poles causes the quadrupole force fields of the two lenses to have coincident principal sections, while the location of the centers in a single plane causes the lenses to have coincident principal planes.

In the preferred embodiment the poles 17, made of ferromagnetic material with windings 19 around them, are rigidly bonded to ceramic spacers 20, which in turn serve to support diamagnetic electrodes 18. The structure thus forms two non-interfering, nested quadrupoles, both of which can have the wide pole-tip radius required to achieve a nearly perfect quadrupole field. Squirrel-cage structures have narrower pole tips and necessarily introduce unwanted multipole field components when they are excited with a quadrupole voltage.

Interleaved lenses can be utilized to form a single quadrupole force field with an adjustable ratio of electric force to magnetic force. The force ratio R is determined by measuring electrode voltages and winding currents, and by formulas relating magnetic field strength and electric field strength to such measurements, according to means well known in the prior art. [S. Ya Yavor, A.D. Dymnikov, and L.P. Ovsyannikova, Nuclear Instruments and Methods 26 (1964) 13-17; F. W. Martin and R. Goloskie, Applied Physics Letters 40 (1982) 191; F.W. Martin and R. Goloskie, Nuclear Instrument and Methods B104 (1995) 95].

When the electric force is adjusted to have half the magnitude of the magnetic force and opposite in direction, so that R = -0.5 , the interleaved lens becomes achromatic to first degree in E. This means that it will image a point object into a spot with a width in one principal section of the form

$$d = C_1 \, a \, dE/E + C_2 \, a \, (dE/E)^2$$

where $C_1 = 0$.

If the electric force is further increased, but not to a magnitude larger than the magnetic force, the interleaved lens becomes a chromatic compensating lens with a negative value of $C_1$ (V. M. Kelman and S. Ya. Yavor, Zuhrnal Tekhnicheskoi Fiziki 33 (1963) 368). For other force ratios it acts as a normal lens with a positive value of $C_1$.

The simplest lens arrangement which can focus in both principal sections is a doublet system. The upstream interleaved lens 14 and downstream interleaved lens 16 compose such a doublet. Spacer 15 serves to adjust the separation of the lenses. A system consisting of two lenses always has a single axis defined by the center of the two lenses, and requires only angular adjustment of the doublet as a whole relative to the input beam in order to function correctly. The doublet has a magnification which differs in its two principal sections, and therefore functions to produce a focused beam which has two different widths, both of which are small.

As shown in Fig. 3, if all the electrodes of the condenser lens are set to the same voltage, it will have no focusing effect and hence produce no chromatic aberration. The functioning elements consist of the ion source 1 and extraction electode 8, and the doublet system 4 of interleaved quadrupole lenses. When the interleaved lenses are set at the achromatic operating point, there is no chromatic aberration introduced by the final focusing lens of the optical column. The focal spot is accordingly smaller than a system of similar dimensions consisting of an ion source, extraction electrode, and an electrostatic lens, when the two systems are operated at the same beam width. This width is set by the adjustable aperture 12. The width may be increased so that the column containing the interleaved lenses produces more current than one containing an electrostatic lens, when the focal spots are the same size.

As shown in Fig 4, when the electrodes of the condenser lens are turned on to appropriate voltages, more of the ions from the source may be directed into the interleaved lens 4. Most of the current from an LMIS occurs within a half angle of about 14 degrees. When the distance from the source to the first lens gap is 9 mm, a parallel beam of about 5 mm full width will be formed, providing that the first lens is of sufficiently large diameter.

The increased angles $a_s$ and $b_s$ which are possible cause increased chromatic aberration in the condenser lens. In order to eliminate the positive chromatic aberration, the doublet of interleaved lenses is adjusted to produce an exactly compensating negative chromatic aberration, as determined by insensitivity of spot size to ion energy E at small settings of the angle-defining aperture 12. Such adjustment compensates all sources of positive 1st-order chromatic aberration, including the aperture lens formed by the hole in the acceleration electrode and the accelerating field in the gap between the source and the extractor. The aperture may then be opened to the point where the remaining higher-order aberrations cause the focused beam to reach a specified spot diameter. The current into the focused spot is thereby increased relative to a system which does not include an interleaved quadrupole lens system for . cancelling chromatic aberration.

It is not immediately obvious that interleaved lenses, which have two independent principal sections, can be adjusted to compensate the chromatic aberration of a round lens. A single interleaved lens cannot, since it introduces aberrations of opposite sign in the two principal sections. However two interleaved lenses introduce two variables, and the simultaneous linear equations for the aberrations in the two principal sections can be solved, given the dimensions of the system. For the parallel-beam geometry of Fig. 4, the coefficients $C_x$, $C_y$ of the two interleaved lenses must satisfy

$$C_x/f_x^2 = C_y/f_y^2 = -C/h^2$$

where $f_x$, $f_y$, are the focal lengths of the doublet 4, and h, C are the focal length and chromatic aberration coefficient of the round lens 2. In a thin-lens approximation, the coefficients $C_{yu}$, $C_{xd}$ in the converging principal sections of the individual upstrean and downstream lenses of the doublet are given by

$$C_{yu} / f_u = - (1 + 2s/v) \, v \, C / 2h^2,$$

$$C_{xd} / f_d = \quad - v \, C / 2h^2,$$

where v is the image distance of the downstream lens, the coefficients in the diverging sections are given by

$$C_{xu} = - C_{yu}, \; C_{yd} = - C_{xd},$$

and s is the separation of the lenses. Different expressions apply when the beam is not parallel. The thin-lens coefficients are themselves of the form

$$C_{yu} / f_u = (2R_u + 1 )/(2R_u + 2)$$

$$C_{xd} / f_d = (2R_d + 1 )/(2R_d + 2)$$

so that the electric-to-magnetic force ratios $R_u$, $R_d$ can be calculated given the interleaved lens dimensions s, v and the condensing lens parameters C, h . In the best mode of operation, a power supply of the type found in the prior art is used, in which the electric and magnetic portions of the interleaved lens are varied in proportion, thereby varying f at fixed R . $R_u$ and $R_d$ are set at values calculated for the C,h of the lens which is to be compensated. Focus is then obtained by varying $f_u$, $f_d$ for the two lenses of the quadrupole doublet, according to procedure well known in the prior art.

Measurement of submicron beam size may be accomplished by using deflectors 11, 13 or a deflector downstream of lens 4. Width can be determined from the deflection required to sweep the focused beam across a knife edge. A method which avoids destruction of the edge by ion-beam sputtering is to measure the electrical charge required to micromachine away a raster-swept region of a thin specimen, when the distance between lines in the raster is smaller than the beam width. A third method of the prior art which does not require submicron test specimens is to measure d as a function of a . When a single ray is produced by making aperture 12 small, equal and opposite settings of deflectors 11 and 13 cause the ray to enter the aperture of the interleaved lens far off its axis and accordingly to have large values of a . When the interleaved lens is improperly adjusted, large and easily measured aberrations d are caused. The calculated magnetic-to-electric ratio in the interleaved lens can then be trimmed to produce minimum chromatic aberration of the ray, rather than minimum spot size.

Systems consisting of a plurality of interleaved lenses can be designed so that the magnification is equal in the two principal sections. The simplest such system is the triplet [L. R. Harriott, W. L. Brown, and D. L. Barr, J. Vac. Sci. Tech. B8 (1990) 1706]. Triplets suffer the disadvantages of extra complexity of operation and of considerable high-precision mechanical fabrication, which is necessary in order to assure that the centers of the three lenses lie on a straight line.

It is not necessary to operate the column with a parallel beam. The condenser lens in general forms an intermediate image of the ion source, which may lie at any position along the axis of the column, including upstream of the ion source or downstream of the final image plane. The column thus forms a so-called zoom lens, in which the minimum size of the image (as determined from the magnification alone without accounting for aberrations) varies as the position of the intermediate image is changed. As shown in Fig. 5, the intermediate image 21 may be located between the condenser lens and the next lens, in which case the beam is said to cross over, since rays from the periphery of the beam cross the system axis.

Ion sources of the liquid alloy type produce several kinds of ions at once and require mass analysis in order to produce a focused beam of a single kind of ion. A Wien velocity filter 22 placed between the condenser lens and the next downstream lens as shown in Fig 6 deflects unwanted ion species off the beam axis, allowing only ions with a given charge-to-mass ratio to proceed undeflected. Although such deflection occurs for intermediate images at any position, producing divergent, parallel, or convergent beams emerging from the condenser lens, the best operation of the column occurs when the crossover 21 occurs in the center of the Wien filter 22, so that chromatic aberrations introduced by the filter are eliminated.

Ions which are deflected enough so that they cannot pass through the aperture of the interleaved lens are completely eliminated from the image which it forms. Although such systems may not separate the closely spaced isotopes of a given element, such as gallium (mass 69,71), they are useful for separating the widely spaced kinds of ions produced by alloy-based ion sources. For example the alloy $Ni_4B_6$ produces $Ni^{+2}$ (charge-to-mass 30, 32% yield) and the commercially important $B^{+1}$ (charge-to-mass 10 or 11, 33% yield). The system comprising an electrostatic condenser lens and an interleaved quadrupole doublet therefore is useful in forming a final image 23 from ions of a single atomic number for such purposes as microfabrication and ion implantation.

Mass analysis generally must be performed at low E, because the combination of massive ions and high energies requires magnetic fields greater than can be provided by air-cooled electromagnets. If mass analysis at high energy is performed, dipole bending magnets which curve the beam in a large radius of curvature are required [Martin US patent 4,555,666]. However ion implantation in semiconductors requires energies of 300kV or higher in order to dope regions which are fractions of a micron deep. As shown in Fig. 7, a high voltage source 24, control electronics 25, and an accelerating gap 26 function to increase the beam energy, while an objective lens 27 focuses the ions into a high-energy final image 28.

When the second intermediate image 23 is placed at the accelerating gap as shown in Fig 7, aberrations introduced by the gap are minimized. The objective lens 27 is any type of lens, including round electrostatic or magnetic lenses, electric, magnetic, or interleaved quadrupoles. The electric-to-magnetic ratio of the lens system 4 of interleaved quadrupoles 14,16 is adjusted to produce minimum spot size at small angles a,b in the plurality of lenses, thereby using its negative chromatic aberration to compensate the positive chromatic aberration of all the other ion-optical components. When chromatic aberration is thereby minimized, the angle-setting apertures may be opened until higher-order aberrations increase spot size.

The column comprising ion source 1, condensing lens 2, interleaved quadrupole system 4, accelerating gap 26, and objective lens 27 thereby functions to produce increased ion current in a final focused spot of a given size.

The most useful arrangement comprises an interleaved quadrupole lens system 4 at low energy, because the electric and magnetic forces are oppositely directed in such a lens, thereby requiring higher fields than a simpler lens to reach the same focusing power. This difficulty is lessened if an interleaved lens is operated with particles of low energy, or it it has a small bore. A useful system is obtained if the objective lens 27 is a magnetic quadrupole doublet, while the second lens 4 is an interleaved lens operating to produce negative chromatic aberration. In this system the objective lens 27 can be utilized to counteract the unequal magnifications introduced by the second lens 4, thereby making the magnification of the system equal in its two principal sections. Another useful system is obtained if the second lens 4 is a large electrostatic lens, and the objective lens 27 is an interleaved system of small bore and short focal length operated to produce negative chromatic aberration.

The essential feature of these particle-beam columns is provision of a plurality of interleaved quadrupole lenses, which taken together have negative chromatic aberration, and which function to compensate the positive chromatic aberration of the other components in the column.

## Claims

1. A method for operating a particle-optical column for forming a finely focused particle beam, the column comprising a needle-type source (1), a condensing lens system (2) including an extraction electrode (8), and a plurality of lenses comprising an interleaved electric and magnetic quadrupole lens system (4), each interleaved lens being an 8-pole lens having poles that are alternately electric and magnetic, **characterised in that** in the quadrupole lens system (4) each interleaved lens of the system is operated at the critical ratio of electric to magnetic fields such that the negative chromatic aberration of the system of interleaved lenses exactly cancels the positive chromatic aberration of all other particle-optical components simultaneously in both principal sections and the spot diameter is substantially independent of small changes in the particle energy.

2. A method as in claim 1, wherein the plurality of lenses is a doublet of said lenses.

3. A method for operating a particle-optical column for forming a finely focused particle beam, the column comprising a needle-type source (1), a condensing lens system (2) including an extraction electrode (8), and a system of lenses (4) consisting of a doublet of interleaved quadrupole lenses (14,16), each interleaved lens being an 8-pole lens having poles that are alternately electric and magnetic, **characterised in that** in the quadrupole lens doublet (14,16) each interleaved lens is operated at the critical ratio of electric to magnetic fields such that it adds no chromatic aberration to any positive chromatic aberration produced by the needle-type particle source and extraction electrode, and the dependence of spot diameter upon energy is reduced in comparison to a column employing only electrostatic lenses to form the fine beam.

4. A method as in any one of claims 1 to 3, for forming a finely focused particle beam in a microfabrication method.

5. A method as in claim 4, wherein the microfabrication method is ion implantation in semiconductors.

6. A method as in claim 4, wherein the microfabrication method is micromachining of materials.

7. A method as in claim 4, wherein the microfabrication method is ion beam lithography.

8. A method as in any one of claims 1 to 3, for forming a finely focused particle beam in a microanalysis method.

9. A method as in claim 8, wherein the microanalysis method is secondary ion microscopy.

10. A method for microfabrication in which a finely focused particle beam is caused to impinge on a material to be microfabricated, the method being **characterised in that** the particle beam is formed by a method as in any one of claims 1 to 7.

11. A method for microanalysis in which a finely focused particle beam is caused to impinge on a material to be microanalysed, the method being **characterised in that** the particle beam is formed by a method as in any one of claims 1 to 3, 8 and 9.

12. A particle-optical column for forming a finely focused particle beam, comprising a needle-type source (1), an extraction electrode (8), and a system of lenses (4) consisting of a doublet of interleaved quadrupole lenses (14,16), each interleaved lens being an 8-pole lens having poles that are alternately electric and magnetic, **characterised in that** there is provided a condensing lens system (2) which includes the extraction electrode (8) and **in that** further there are provided means for (i) controlling the ratio of electric to magnetic fields in the doublet of interleaved quadrupole lenses (14,16) such that the negative chromatic aberration of the doublet of interleaved lenses exactly cancels the positive chromatic aberration of all other particle-optical components simultaneously in both principal sections and the spot diameter is substantially independent of small changes in the particle energy, or (ii) controlling the ratio of electric to magnetic fields in the doublet of interleaved quadrupole lenses (14,16) such that no chromatic aberration is added to any positive chromatic aberration produced by the needle-type particle source and the extraction electrode, and the dependence of spot diameter upon energy is reduced in comparison to a column employing only electrostatic lenses to form the fine beam.

**13.** A particle-optical column as in claim 12, further comprising an aperture-defining assembly (12) to control the width of the beam.

**14.** A particle-optical column as in claim 13, wherein the aperture-defining assembly (12) is adjustable to vary the beam width.

**15.** A particle-optical column as in any of claims 12 to 14, further comprising a Wien velocity filter (22) located between the ion source (1) and the interleaved quadrupole lenses (14,16) which serves to produce a finely focused beam of particles of a single mass.

**16.** A method for microfabrication in which a finely focused particle beam is caused to impinge on a material to be microfabricated, the method being **characterised in that** the particle beam is formed using a particle-optical column as in any one of claims 12 to 15.

**17.** A method for microanalysis in which a finely focused particle beam is caused to impinge on a material to be microanalysed, the method being **characterised in that** the particle beam is formed using a particle-optical column as in any one of claims 12 to 15.

**Patentansprüche**

**1.** Verfahren zum Betreiben einer optischen Teilchensäule zur Erzeugung eines dünn fokussierten Teilchenstrahls, wobei die Säule umfasst:

- eine nadelartige Quelle (1),
- ein Kondensorsystem (2), welches eine Absaugelektrode (8) enthält, und
- eine Vielzahl an Linsen, umfassend ein verschachteltes elektrisches und magnetisches Quadrupollinsensystem (4), wobei es sich bei jeder verschachtelten Linse um eine achtpolige Linse handelt, welche abwechselnd elektrische und magnetische Pole aufweist,

**dadurch gekennzeichnet,**
**dass** in dem Quadrupollinsensystem (4) jede verschachtelte Linse des Systems bei einem kritischen Verhältnis von elektrischen zu magnetischen Feldern betrieben wird, derart, dass die negative chromatische Aberration des Systems der verschachtelten Linsen genau die positive chromatische Aberration aller anderen optischen Teilchenkomponenten gleichzeitig in beiden Hauptebenen aufhebt und der Spotdurchmesser im Wesentlichen unabhängig von kleinen Änderungen der Teilchenenergie ist.

**2.** Verfahren nach Anspruch 1, wobei es sich bei der Vielzahl an Linsen um ein Dublett dieser Linsen handelt.

**3.** Verfahren zum Betreiben einer optischen Teilchensäule zur Erzeugung eines dünn fokussierten Teilchenstrahls, wobei die Säule umfasst:

- eine nadelartige Quelle (1),
- ein Kondensorsystem (2), welches eine Absaugelektrode (8) beinhaltet,
- und ein Linsensystem (4), welches aus einem Dublett von verschachtelten Quadrupollinsen (14, 16) besteht, wobei es sich bei jeder verschachtelten Linse um eine achtpolige Linse handelt, welche abwechselnd elektrische und magnetische Pole aufweist,

**dadurch gekennzeichnet,**
**dass** in dem Quadrupollinsen-Dublett (14, 16) jede verschachtelte Linse bei einem kritischen Verhältnis von elektrischen zu magnetischen Feldern betrieben wird, derart, dass keine chromatische Aberration zu irgendeiner positiven chromatischen Aberration, welche von der nadelartigen Teilchenquelle und der Absaugelektrode erzeugt wurde, hinzugefügt wird, und die Energieabhängigkeit des Spotdurchmessers verglichen mit einer Säule, welche zur Erzeugung des dünnen Strahls lediglich elektrostatische Linsen verwendet, reduziert ist.

**4.** Verfahren nach einem der Ansprüche 1 bis 3 zur Ausbildung eines dünn fokussierten Teilchenstrahls bei einem Mikrofabrikationsverfahren.

5. Verfahren nach Anspruch 4, wobei es sich dem Mikrofabrikationsverfahren um Ionenimplantation in Halbleitern handelt.

6. Verfahren nach Anspruch 4, wobei es sich bei dem Mikrofabrikationsverfahren um eine Mikromaterialbearbeitung handelt.

7. Verfahren nach Anspruch 4, wobei es sich bei dem Mikrofabrikationsverfahren um Tonenstrahllithographie handelt.

8. Verfahren nach einem der Ansprüche 1 bis 3 zur Ausbildung eines dünn fokussierten Teilchenstrahls bei einem Mikroanalyseverfahren.

9. Verfahren nach Anspruch 8, wobei es sich bei dem Mikroanalyseverfahren um Sekundärionenmikrokospie handelt.

10. Verfahren zur Mikrofabrikation, bei welchem ein dünn fokussierter Teilchenstrahl ein zur Mikrofabrikation bestimmtes Material beaufschlagt, wobei das Verfahren **dadurch gekennzeichnet ist, dass** der Teilchenstrahl mithilfe eines Verfahrens nach einem der Ansprüche 1 bis 7 erzeugt wird.

11. Verfahren zur Mikroanalyse, bei welchem ein dünn fokussierter Teilchenstrabl ein zur Mikroanalyse bestimmtes Material beaufschlagt, wobei das Verfahren **dadurch gekennzeichnet ist, dass** der Teilchenstrahl mithilfe eines Verfahrens nach einem der Ansprüche 1 bis 3, 8 und 9 erzeugt wird.

12. Optische Teilchensäule zur Erzeugung eines dünn fokussierten Teilchenstrahls, **umfassend**
eine nadelartige Quelle (1), eine Absaugelektrode (8), und ein Linsensystem (4) bestehend aus einem Dublett von verschachtelten Quadrupollinsen (14, 16), wobei es sich bei jeder verschachtelten Linse um eine achtpolige Linse handelt, welche abwechselnd elektrische und magnetische Pole aufweist, **dadurch gekennzeichnet ,**
**dass** ein Kondensorsystem (2) vorgesehen ist, welches die Absaugelektrode (8) enthält, und
**dass** des weiteren Vorrichtungen vorgesehen sind zur

(i) Kontrolle des Verhältnisses von elektrischen zu magnetischen Feldern in dem Dublett der verschachtelten Quadrupollinsen (14, 16) derart, dass die negative chromatische Aberration des Dubletts der verschachtelten Linsen genau die positive chromatische Aberration aller anderen optischen Teilchenkomponenten gleichzeitig in beiden Hauptebenen aufhebt, und der Spotdurchmesser im Wesentlichen unabhängig von kleinen Änderungen der Teilchenenergie ist, oder
(ii) zur Kontrolle des Verhältnisses von elektrischen zu magnetischen Feldern innerhalb des Dubletts der verschachtelten Quadrupollinsen (14, 16) derart, dass keine chromatische Aberration zu irgendeiner positiven chromatischen Aberration hinzugefügt wird, welche von der nadelartigen Teilchenquelle und der Absaugelektrode erzeugt wird, und die Energieabhängigkeit des Spotdurchmessers verglichen mit einer Säule, welche zur Erzeugung des dünnen Stahls lediglich elektrostatische Linsen verwendet, reduziert ist.

13. Eine optische Teilchensäule nach Anspruch 12, welche des weiteren eine eine Apertur definierende Vorrichtung (12) zur Kontrolle der Strahlbreite umfasst.

14. Eine optische Teilchensäule nach Anspruch 13, wobei die die Apertur definierende Vorrichtung (12) regelbar ausgestaltet ist, um die Strahlweite zu variieren.

15. Eine optische Teilchensäule nach einem der Ansprüche 12 bis 14, des weiteren umfassend einen Wien'schen Geschwindigkeitsfilter (22), welcher zwischen der Ionenquelle (1) und den verschachtelten Quadrupollinsen (14, 16) angeordnet ist und dazu dient, einen dünn fokussierten Strahl von Teilchen einer einzigen Masse zu erzeugen.

16. Verfahren zur Mikrofabrikation, bei welchem ein dünn fokussierter Teilchenstrahl ein zur Mikrofabrikation bestimmtes Material beaufschlagen soll, wobei das Verfahren **dadurch gekennzeichnet ist, dass** der Teilchenstrahl mithilfe einer optischen Teilchensäule nach einem der Ansprüche 12 bis 15 erzeugt wird.

17. Verfahren zur Mikroanalyse, bei der ein dünn fokussierter Teilchenstrahl ein zur Mikroanalyse bestimmtes Material beaufschlagt, wobei das Verfahren **dadurch gekennzeichnet ist, dass** der Teilchenstrahl mithilfe einer optischen Teilchensäule nach einem der Ansprüche 12 bis 15 erzeugt wird.

**Revendications**

1. Procédé pour faire fonctionner une colonne d'optique corpusculaire pour former un faisceau de corpuscules finement focalisé, la colonne comprenant une source (1) de type aiguille, un système de condenseur à lentilles comprenant une électrode (8) d'extraction, et une pluralité de lentilles comprenant un système (4) de lentilles quadrupolaires imbriquées électriques et magnétiques, chaque lentille imbriquée étant une lentille à 8 pôles ayant des pôles qui sont alternativement électriques et magnétiques, **caractérisé en ce que** dans le système (4) à lentilles quadrupolaires chaque lentille imbriquée du système fonctionne au rapport critique des champs électrique à magnétique tel que l'aberration chromatique négative du système de lentilles imbriquées supprime exactement l'aberration chromatique positive de tous les autres éléments de l'optique corpusculaire simultanément dans les deux sections principales et que le diamètre du spot soit sensiblement indépendant de petits changements de l'énergie des corpuscules.

2. Procédé suivant la revendication 1, dans lequel la pluralité de lentilles est un doublet de lentilles.

3. Procédé pour faire fonctionner une colonne d'optique corpusculaire pour former un faisceau de corpuscules finement focalisé, la colonne comprenant une source (1) de type aiguille, un système de condenseur à lentilles comprenant une électrode (8) d'extraction, et un système (4) de lentilles consistant en un doublet de lentilles (14, 16) quadrupolaires imbriquées, chaque lentille imbriquée étant une lentille à 8 pôles ayant des pôles qui sont alternativement électriques et magnétiques, **caractérisés en ce que** dans le doublet (14, 16) de lentilles quadrupolaires chaque lentille imbriquée fonctionne au rapport critique des champs électrique à magnétique de façon à ce qu'elle n'ajoute pas d'aberration chromatique à une aberration chromatique positive produite par la source de corpuscules de type à aiguille et par l'électrode d'extraction et de façon à ce que la variation du diamètre du spot avec l'énergie soit réduite par rapport à une colonne utilisant seulement des lentilles électrostatiques pour former le faisceau fin.

4. Procédé suivant l'une quelconque des revendications 1 à 3, pour former un faisceau de corpuscules finement focalisé dans un procédé de microfabrication.

5. Procédé suivant la revendication 4, dans lequel le procédé de microfabrication est une implantation d'ions dans des semi-conducteurs.

6. Procédé suivant la revendication 4, dans lequel le procédé de microfabrication est un micro-usinage de matériaux.

7. Procédé suivant la revendication 4, dans lequel le procédé de microfabrication est une lithographie par faisceau d'ions.

8. Procédé suivant l'une quelconque des revendications 1 à 3, pour former un faisceau de corpuscules finement focalisé dans un procédé de micro-analyse.

9. Procédé suivant la revendication 8, dans lequel le procédé de micro-analyse est une microscopie ionique secondaire.

10. Procédé de microfabrication, dans lequel on fait arriver un faisceau de corpuscules finement focalisé sur un matériau à microfabriquer, le procédé étant **caractérisé en ce que** le faisceau de corpuscules est formé par un procédé suivant l'une quelconque des revendications 1 à 7.

11. Procédé de micro-analyse, dans lequel on fait arriver un faisceau de corpuscules finement focalisé sur un matériau à micro analyser, le procédé étant **caractérisé en ce que** le faisceau de corpuscules est formé par un procédé suivant l'une quelconque des revendications 1 à 3, 8 et 9.

12. Colonne d'optique corpusculaire pour former un faisceau de corpuscules finement focalisé, comprenant une source (1) de type aiguille, une électrode (8) d'extraction et un système de lentilles (4) consistant en un doublet de lentilles (14, 16) quadrupolaires imbriquées, chaque lentille imbriquée étant une lentille à 8 pôles ayant des pôles qui sont alternativement électriques et magnétiques, **caractérisée en ce qu'**il est prévu un système (2) condenseur à lentilles qui comprend l'électrode (8) d'extraction et **en ce qu'**il est prévu, en outre, des moyens destinés (i) à se rendre maître du rapport des champs électrique à magnétique dans le doublet de lentilles (14, 16) quadrupolaires imbriquées de façon à ce que l'aberration chromatique négative du doublet de lentilles imbriquées supprime exactement l'aberration chromatique positive de tous les autres éléments d'optique corpusculaire simultanément dans les deux sections principales et de manière à ce que le diamètre du spot soit sensiblement indépendant de petits changements de l'énergie des corpuscules, ou (ii) à se rendre maître du rapport des champs électrique à magnétique dans le doublet de lentilles (14,16) quadrupolaires imbriquées de façon à ce qu'une aberration chromatique ne soit pas ajoutée à une aberration chromatique positive produite par la source de corpuscules de type aiguille et par l'électrode d'extraction, et de manière à ce que la variation du diamètre du spot en fonction de l'énergie soit réduite en comparaison d'une colonne utilisant seulement des lentilles électrostatiques pour former le faisceau fin.

13. Colonne à optique corpusculaire suivant la revendication 12, comprenant en outre un ensemble (12) définissant une ouverture pour se rendre maître de la largeur du faisceau.

14. Colonne à optique corpusculaire suivant la revendication 13, dans lequel l'ensemble (12) définissant une ouverture est réglable pour faire varier la largeur du faisceau.

15. Colonne à optique corpusculaire suivant l'une quelconque des revendications 12 à 14, comprenant en outre un filtre (22) de vitesse de Wien interposé entre la source (1) d'ion et des lentilles (14,16) quadrupolaires imbriquées, qui sert à produire un faisceau finement focalisé de corpuscules ayant une masse unique.

16. Procédé de microfabrication, dans lequel on fait arriver un faisceau de corpuscules finement focalisé sur un matériau à microfabriquer, le procédé étant **caractérisé en ce que** le faisceau de corpuscules est formé en utilisant une colonne d'optique corpusculaire suivant l'une quelconque des revendications 12 à 15.

17. Procédé de micro-analyse, dans lequel on fait arriver un faisceau de corpuscules finement focalisé sur un matériau à microanalyser, le procédé étant **caractérisé en ce que** le faisceau de corpuscules est formé en utilisant une colonne d'optique corpusculaire suivant l'une quelconque des revendications 12 à 15.

Fig.2

Fig.1

Fig.3

Fig.4

Fig.5

Fig.6

Fig.7